# EUROPEAN PATENT APPLICATION

(11) **EP 4 456 676 A1**
(43) Date of publication of application: **30.10.2024**
(21) Application number: 22911356.8
(22) Date of filing: 22.12.2022
(51) Int. Cl.: H05K 1/02, H01L 23/12, H01L 23/13, H01L 23/15, H05K 3/00

(54) **CERAMIC SCRIBE CIRCUIT SUBSTRATE, CERAMIC CIRCUIT SUBSTRATE, METHOD FOR MANUFACTURING CERAMIC SCRIBE CIRCUIT SUBSTRATE, METHOD FOR MANUFACTURING CERAMIC CIRCUIT SUBSTRATE, AND METHOD FOR MANUFACTURING SEMICONDUCTOR DEVICE**

(30) Priority: 22.12.2021 JP 2021207743
(71) Applicant: Kabushiki Kaisha Toshiba, Tokyo 105-0023 (JP); Toshiba Materials Co., Ltd., Isogo-Ku Yokohama-Shi Kanagawa 235-0032 (JP)
(72) Inventor: MATSUMOTO, Yukihisa, Yokohama-shi, Kanagawa 235-0032 (JP)
(74) Representative: Hoffmann Eitle
(86) International application number: PCT/JP2022/047401
(87) International publication number: WO 2023/120654

(57) **Abstract**

A scribed ceramic substrate according to the embodiment comprises: a ceramic circuit substrate including a ceramic substrate and a metal circuit bonded thereto; and a scribe line defining the ceramic substrate, wherein the scribe line includes a continuous groove on a front surface side thereof, and the continuous groove is composed of a plurality of holes connected to each other, the plurality of holes formed by fiber laser irradiation, wherein a depth of the continuous groove is more than 40 µm, and 0.15 times or more and 0.5 times or less a thickness of the ceramic substrate.

## Description

### TECHNICAL FIELD

Embodiments generally relate to a scribed ceramic circuit substrate, a ceramic circuit substrate, a method for producing the scribed ceramic circuit substrate, a method for producing the ceramic circuit substrate, and a method for producing a semiconductor device.

### BACKGROUND ART

With development of semiconductor elements that need a large current, such as power electronics and next-generation power semiconductors, demand for the ceramic circuit substrate that has both heat dissipation and electrical insulating properties has recently increased year by year. In particular, as the heat generated by the elements increases with miniaturization and high performance, a thinner ceramic substrate tends to be used in order to dissipate the heat more efficiently. In addition, a thicker metal circuit tends to be used in order to carry large currents.

On the other hand, in order to reduce production cost of the ceramic substrate, it is often produced in a larger shape and divided into a product size. For a silicon nitride substrate, which has high strength, high toughness, and high heat dissipation among the ceramic substrates, a multi-piece taking method involving use of scribe lines formed by laser processing is disclosed as one of the methods for dividing it into the product size (Patent Document 1). According to Patent Document 1, microcracks in the silicon nitride substrate do not occur unnecessarily during division associated with multi-piece taking by the laser processing, and scribe line processing for multi-piece taking can be performed easily and at low cost.

In contrast, there is disclosed a method including forming a scribe line on a ceramic substrate by laser processing, bonding a metal plate by an active metal method, and forming a circuit by an etching method (Patent Document 2). According to Patent Document 2, the laser processing was performed before bonding a copper plate. If it was performed after the etching, the metal was precipitated to decrease insulation resistance. As a laser processing method after bonding the copper plate to the ceramic substrate, a processing method in which laser power and laser speed are controlled is disclosed (Patent Document 3). According to Patent Document 3, the metal (copper) on the ceramic substrate (Al₂O₃) is ablated (removed) to obtain a good appearance, and a substrate can be obtained with almost no residue and no oxidation of copper. However, this method requires limitation of the laser power and the laser speed. Even when they were limited, slight residue and copper oxidation occurred though very good appearance was obtained.

The ceramic substrate before being divided is larger and thinner and the metal circuit is thicker. Accordingly, a residual stress after bonding is larger due to the difference in the thermal expansion coefficient between the two, and problems arising from laser processing of ceramic circuit substrates have become apparent. For example, since the silicon nitride substrate has high strength, a large force is required to break along the scribe line, so the laser must be applied deep in the thickness direction of the silicon nitride substrate. However, if the silicon nitride substrate is thin, there is a high probability that it will be divided by the force applied during processing after forming the scribe line by the laser or during transportation. In contrast, if the laser is applied shallowly in the thickness direction of the silicon nitride substrate, there is a low probability that it will be divided during processing; however, a large force must be applied to break it, which causes a work load, and the large force applied may cause chipping or cracking on an outer periphery.

Namely, it is possible to form a scribe line by laser processing on the ceramic substrate before being divided, but it has been found that it is necessary to control a processing method of the scribe line in order to improve work efficiency after forming the scribe line and to prevent chipping and cracking.

### PRIOR ART DOCUMENTS

### PATENT DOCUMENT

Patent Document 1: Japanese Patent Laid-Open No. 2002-176119
Patent Document 2: Japanese Patent Laid-Open No. 2007-324301
Patent Document 3: Japanese Patent Laid-Open No. 2020-524607

### SUMMARY OF THE INVENTION

### PROBLEMS TO BE SOLVED BY THE INVENTION

In recent years, as a junction temperature of a power semiconductor chip has increased, high reliability of the circuit substrate has been demanded. Therefore, there is a need for a high-strength and thin ceramic circuit substrate that has both the heat dissipation and electrical insulation properties without impairing the high reliability.

The embodiment solves such problems and relates to a scribed ceramic circuit substrate that has excellent cost performance and that enables efficient production of small ceramic circuit substrates from a large ceramic scribe circuit substrate having both the heat dissipation and electrical insulation properties, having high-strength, and being thin.

### MEANS FOR SOLVING THE PROBLEMS

A scribed ceramic circuit substrate according to the embodiment comprises: a ceramic circuit substrate including a ceramic substrate and a metal circuit bonded thereto; and a scribe line defining the ceramic substrate, wherein the scribe line includes a continuous groove on a front surface side thereof, and the continuous groove is composed of a plurality of holes connected to each other, the plurality of holes formed by fiber laser irradiation, wherein a depth of the continuous groove is more than 40 µm, and 0.15 times or more and 0.5 times or less a thickness of the ceramic substrate.

### BRIEF DESCRIPTION OF THE DRAWINGS

FIG. 1 is a top view showing an example of a laser-scribed surface (front surface) of a scribed ceramic circuit substrate according to the embodiment.
FIG. 2 is a bottom view showing a back surface of the scribed ceramic circuit substrate according to the embodiment.
FIG. 3 is a side view of the scribed ceramic circuit substrate shown in FIG. 1.
FIG. 4 is a top view showing an example of a surface to which a brazing material is applied by printing when producing a scribed ceramic circuit substrate according to the embodiment.
FIG. 5 is a side view of the scribed ceramic circuit substrate shown in FIG. 4.
FIG. 6 is a side view after mounting a metal plate in the scribed ceramic circuit substrate according to the embodiment.
FIG. 7 is a cross-sectional view showing an example of the scribed ceramic circuit substrate according to the embodiment.
FIG. 8 is a partial cross-sectional view in which a portion A of FIG. 7 is roughly enlarged.
FIG. 9 is a side view showing an example of the ceramic circuit substrate according to the embodiment.
FIG. 10 is a side view showing an example of a semiconductor module integrated by resin molding according to the embodiment.

### DESCRIPTION OF EMBODIMENTS

Hereinafter, embodiments of a scribed ceramic circuit substrate, a ceramic circuit substrate, a method for producing the scribed ceramic circuit substrate, a method for producing the ceramic circuit substrate, and a method for producing a semiconductor device will be described in detail with reference to the drawings.

A scribe line of the scribed ceramic circuit substrate according to the embodiment is for defining the ceramic circuit substrate, and encompasses a scribe line before the scribed ceramic circuit substrate is divided into the ceramic circuit substrate and a scribe line mark after it is divided into the ceramic circuit substrate (hereinafter, both of them are referred to as "scribe line"). In the scribed ceramic circuit substrate having the scribe line, the scribe line includes a continuous groove composed of a plurality of holes connected to each other, the plurality of holes formed by irradiation of a laser, e.g., a fiber laser, wherein a depth of the continuous groove is more than 40 µm from a laser irradiation surface side, and 0.15 times or more and 0.5 times or less a thickness of a substrate.

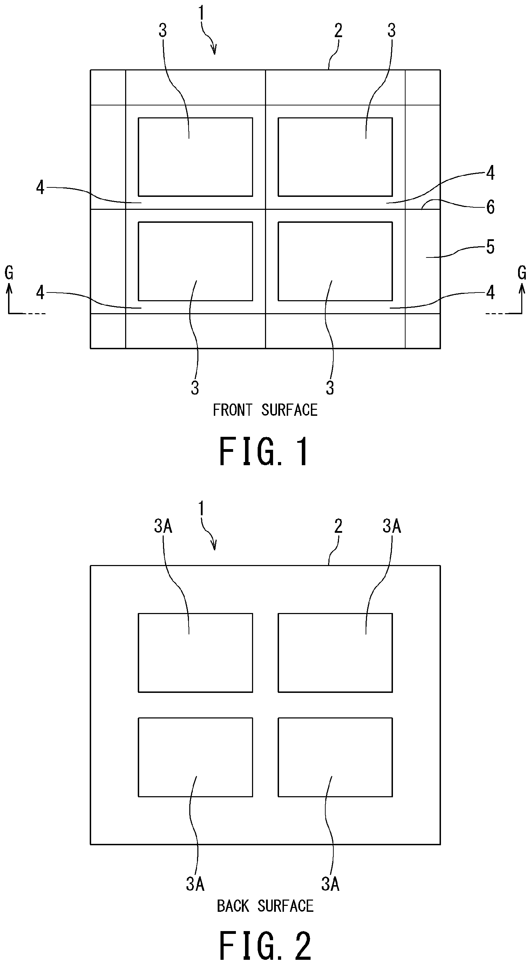

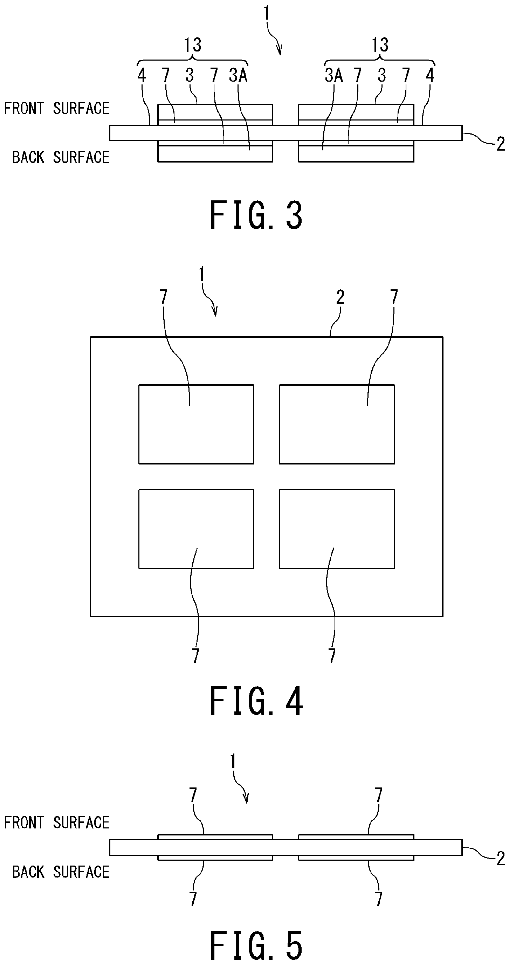

FIG. 1 shows a top view of an example of a laser-scribed surface (front surface) of the scribed ceramic circuit substrate according to the embodiment. FIG. 2 shows a bottom view of FIG. 1, and FIG. 3 shows a side view, in which an upper side is the front surface. Here reference numeral 2 denotes an entire multi-piece ceramic substrate; reference numeral 3 denotes a metal circuit; reference character 3A denotes a metal heat sink; reference numeral 4 denotes a ceramic substrate (four ceramic substrates); reference numeral 5 denotes a periphery portion, which is not used as a product; reference numeral 6 denotes a scribe line; reference numeral 7 denotes a bonding layer (e.g., a brazing material portion); and reference numeral 13 denotes a ceramic circuit substrate to be a product (four ceramic circuit substrates). As shown in FIG. 3, the ceramic circuit substrate 13 may include the ceramic substrate 4, and also the metal circuit 3 and the metal heat sink 3A, both bonded to the ceramic substrate 4 through the brazing material portion 7.

The scribed ceramic circuit substrate 1 encompasses the multi-piece ceramic substrate 2, from which a plurality of ceramic circuit substrates can be obtained by division, and a one-piece ceramic substrate (not shown), from which a single ceramic circuit substrate can be obtained by division. FIG. 1 shows an example of the multi-piece ceramic substrate 2 from which a plurality of the ceramic circuit substrates 13, specifically 2x2 vertically and horizontally, namely four in total, can be obtained by laser scribe along the scribe lines 6, specifically 3x3 vertically and horizontally, namely six in total. The scribed ceramic circuit substrate 1 is not limited to this type of the multi-piece ceramic substrate 2, and the scribed ceramic circuit substrate 1 may be a one-piece ceramic substrate with scribe lines enabling the ceramic circuit substrate to be processed into a product shape, or a multi-piece ceramic substrate with scribe lines enabling a plurality of ceramic circuit substrate, more than 2x2 vertically and horizontally, to be obtained. It is not necessary to form the scribe lines 6 all around a circumference of the ceramic substrate 4, and it should be one or more. In FIG. 1, the scribed ceramic circuit substrate 1 has a rectangular shape in the top view, but it may have an approximately polygonal shape.

When the multi-piece ceramic substrate 2 is a silicon nitride substrate, its three-point bending strength can be as high as 600 MPa or more, and even 700 MPa or more. There is one having a thermal conductivity of 50 W/m·K or more, and even 80 W/m·K or more. When the multi-piece ceramic substrate 2 is an aluminum nitride substrate, the thermal conductivity can be as high as 170 W/m·K or more, and even 230 W/m·K or more. There is one having a three-point bending strength of 350 MPa or more, and even 450 MPa or more. In particular, there are silicon nitride and aluminum nitride substrates that have both high strength and high thermal conductivity.

These multi-piece ceramic substrates 2 can be a single plate or have a three-dimensional structure such as a multilayer structure.

The scribe line 6 is a laser scribe line formed by a laser. The laser is preferably a fiber laser. The fiber laser has a small spot diameter and therefore enables thin and deep machining at high speed. The term "fiber laser" refers to those in accordance with the definition in JIS-Z 3001-5 (2013).

A metal plate used for the metal circuit 3 may be of copper (Cu), copper-based alloys, or aluminum (Al), for example. The ceramic substrate 4 and the metal circuit 3 are preferably bonded through the bonding layer 7. When bonding the metal heat sink 3A, it is also preferable to bond it through the bonding layer 7. It is also preferable to provide the bonding layer 7 between the ceramic substrate 4 and the metal circuit 3, the bonding layer 7 formed of an active metal brazing material containing an active metal such as Ti (titanium). Alternatively to Ti, the active metal may be Zr (zirconium). Examples of the active metal brazing material includes a mixture of Ti and either Ag (silver) or Cu as a main component. An example of the active metal brazing material containing Ti, Ag, and Cu contains: 0.1 wt% or more and 10 wt% or less of Ti, 10 wt% or more and 60 wt% or less of Cu; and Ag as the balance. One or more elements selected from the group consisting of In (indium), Sn (tin), Al, Si (silicon), C (carbon), and Mg (magnesium) may also be added in an amount of 1 wt% or more and 15 wt% or less, if necessary.

In an active metal bonding method involving use of the metal brazing material, it is preferable to prepare a paste of the active metal brazing material. The paste is a mixture of brazing material components and organic materials, and the brazing material components must be uniformly mixed. This is because uneven distribution of the brazing material components can cause unstable brazing and therefore bond failure. The active metal brazing paste is printed on a ceramic substrate surface, and the metal circuit 3 is placed on it. FIG. 4 shows an example of a surface printed with the brazing material when the scribed ceramic circuit substrate 1 according to the embodiment is produced. FIG. 4 shows a front surface of the scribed ceramic circuit substrate 1 in production, and also shows a back surface. FIG. 5 also shows a side view of FIG. 4. This is heated at 600°C or more and 900°C or less to bond the metal circuit 3. By the active metal bonding method, bond strength between the ceramic substrate 4 and the metal circuit 3 can be 16 kN/m or more.

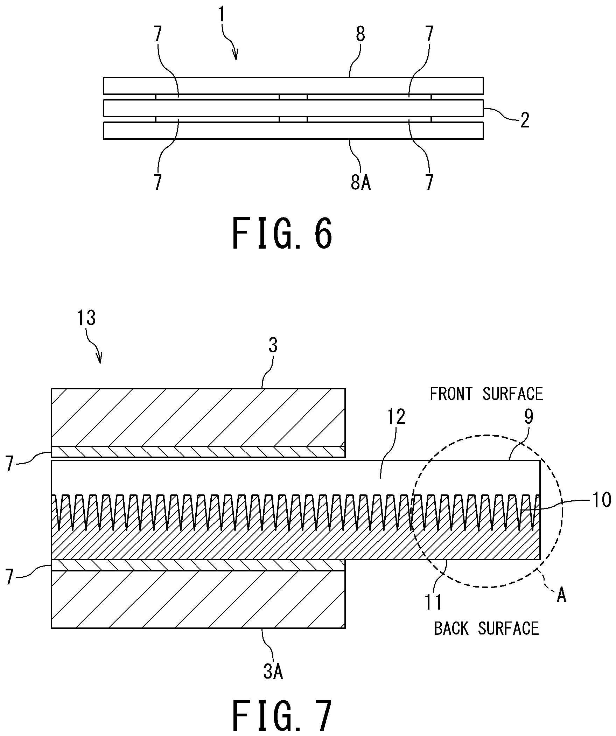

Returning to the explanations of FIG. 1 to FIG. 3, the metal plate to be bonded as the metal circuit 3 can be either one that has been worked in advance into a pattern shape for circuit formation or a single metal plate that has not been worked into a pattern shape yet. FIG. 6 shows a side view after brazing a single metal plate for the ceramic circuit substrate according to the embodiment. Each of reference numeral and character 8 and 8A is a metal plate (e.g., copper plate). In a case where the single plate is used, the metal plate is bonded and then subjected to an etching process to work into a pattern shape. It is also possible to apply the brazing material to the entire surface of the ceramic substrate by printing, bond the metal plate, and then etch the metal plate together with the brazing material, to thereby form a circuit. A thickness of the metal plate is not limited, but is preferably 0.3 mm or more, even 0.6 mm or more. When the metal plate is thicker, a higher current carrying capacity can be obtained, and heat dissipation can also be improved.

Returning to the explanation of FIG. 1 to FIG. 3, a metal thin film including mainly one selected from the group consisting of Ni (nickel), Ag (silver), and Au (gold) may be provided on a surface of the metal circuit 3. Examples of the metal thin film include plated films and sputtered films. The metal thin film can improve corrosion resistance and solder wettability.

FIG. 7 shows an example of a cross-section of the scribed ceramic circuit substrate 1 according to the embodiment. FIG. 7 shows a G-G cross-section of FIG. 1. Reference numeral 9 denotes a laser-irradiated surface (front surface), which is subjected to laser irradiation; reference numeral 12 denotes a continuous groove composed of a plurality of holes connected to each other on the surface side, the plurality of holes formed by the laser irradiation; reference numeral 10 denotes a plurality of holes not connected on a deeper side (a plurality of recesses), the plurality of holes formed by the laser irradiation; and reference numeral 11 denotes a non-laser-irradiated surface (back surface), which is not subjected to laser irradiation and is a surface opposite from the laser-irradiated surface 9. The continuous groove 12 should be provided on the scribed ceramic circuit substrate 1 such that at least one of four scribe lines 6 of the ceramic substrate 4 of the ceramic circuit substrate 13 in the scribed ceramic circuit substrate 1 includes the continuous groove 12 on the front surface side thereof.

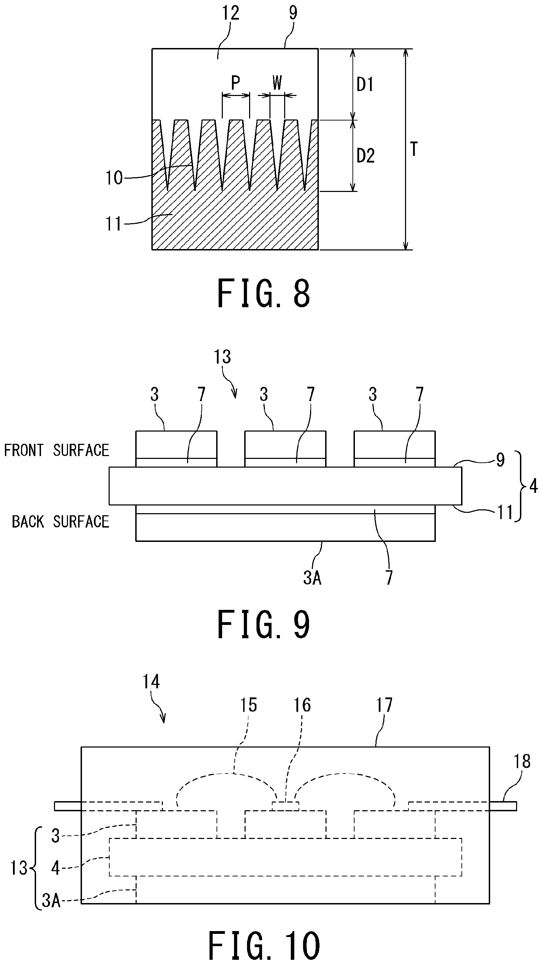

FIG. 8 is an enlarged portion A of FIG. 7. Reference character T denotes a thickness of each ceramic substrate of the multi-piece ceramic substrate 2; reference character D1 denotes a distance from the surface of the ceramic substrate to the deepest point of the continuous groove 12 (depth of the continuous groove 12); and reference character D2 denotes a distance from the deepest point of the continuous groove 12 to the deepest point of the group of non-continuous holes 10 (depth of the group of non-continuous holes 10). Since the multi-piece ceramic substrate 2 is a type of ceramic substrate, the thickness of the multi-piece ceramic substrate 2 is the same as the thickness of the ceramic substrate 4.

The depth of the continuous groove 12, D1, and the depth of the group of non-continuous holes 10, D2, can be determined in the cross-section of the ceramic substrate. The cross-section of the ceramic substrate 4 after being divided along the scribe line 6 is photographed under a microscope or a scanning electron microscope (SEM). In an enlarged photograph, a line parallel to the surface of the ceramic substrate 4 is drawn through the deepest point of the continuous groove 12 (peak between adjacent holes in the group of non-continuous holes 10), and the distance from the surface of the ceramic substrate 4 to the deepest point is measured as the depth D1. Similarly, a line parallel to the surface of the image showing the ceramic substrate 4 is drawn through the deepest point of the group of non-continuous holes 10 in the enlarged photograph, and the distance from the deepest point of the continuous groove 12 to the deepest point of the group of non-continuous holes 10 is measured as the depth D2. Thus, the depth D1 and the depth D2 can be obtained in a simplified manner. The depth of the continuous groove 12, D1 can be measured at a position of a single peak in the group of non-continuous holes 10. Alternatively, the depth D1 can be measured at each position of a plurality of equally spaced peaks in the group of non-continuous holes 10, e.g., 10 peaks, followed by arithmetically averaging the found values. As the depth of the group of non-continuous holes 10, D2, the depth of one hole in the group of non-continuous holes 10 can be measured, or each depth of a plurality of equally spaced holes in the group of non-continuous holes 10, e.g., 10 holes can be measured, followed by arithmetically averaging the found values.

The depth of the continuous groove 12 from the laser-irradiated surface 9, D1, is more than 40 µm. The continuous groove 12 is formed to smoothly divide a ceramic substrate having high strength. A depth of the continuous groove 12 of more than 40 µm makes it unnecessary to apply a large force when dividing the substrate. Furthermore, the depth of the continuous groove 12 is preferably more than 70 µm, more preferably more than 90 µm.

On the other hand, the depth of the continuous groove 12, D1, is 0.15 times or more and 0.5 times or less the thickness T of the ceramic substrate 4. If the depth D1 is less than 0.15 times the thickness T of the ceramic substrate 4, a large force will be applied during division, and failures such as fractures or cracks are likely to occur at a dividing point of the ceramic substrate 4 after dividing. If the depth D1 is more than 0.5 times the thickness T of the ceramic substrate 4, even a small force applied during processing or transportation will cause division, making stable production impossible. Furthermore, the depth D1 of the continuous groove 12 is preferably 0.2 times or more and 0.45 times or less the thickness T of the ceramic substrate 4, more preferably 0.25 times or more and 0.4 times or less.

The depth D2 of the group of non-continuous holes 10 formed on a deeper side than the continuous groove 12 is more than 0 and 0.45 times or less the thickness of the ceramic substrate 4. If the depth D2 is more than 0.45 times the thickness T of the ceramic substrate 4, even a small force applied during processing or transportation will cause division, making stable production impossible. Furthermore, the depth of the group of non-continuous holes 10, D2, is preferably 0.05 times or more and 0.4 times or less the thickness T of the ceramic substrate 4, more preferably 0.1 times or more and 0.35 times or less.

In FIG. 8, W denotes a width of an opening of the group of non-continuous holes 10 (hereinafter referred to as "hole opening width"); and P denotes a distance between adjacent holes of the group of non-continuous holes 10 (hereinafter referred to as "inter-hole distance"). In FIG. 8, the inter-hole distance P of the group of non-continuous holes 10 is measured as the distance between the deepest points of the adjacent holes, but it is also possible to measure the distance between the shallowest points of the adjacent holes.

The hole opening width W and the inter-hole distance P are obtained by measuring the inter-hole distance P and the hole opening width W between adjacent holes, for example, at the 10 points where the above-mentioned depth D2 was measured, and arithmetically averaging the found values.

The inter-hole distance P of the group of non-continuous holes 10 is preferably 10 µm or more and 100 µm or less. If the inter-hole distance P is more than 100 µm, a large force will be applied during division, and failures such as chipping and cracking are likely to occur at the dividing point of the ceramic substrate 4. If the inter-hole distance P is less than 10 µm, only a small force applied during processing or transportation will cause division, making stable production impossible. Furthermore, the inter-hole distance P of the group of non-continuous holes 10 is preferably 20 µm or more and 90 µm or less, more preferably 30 µm or more and 80 µm or less.

The hole opening width W of the group of non-continuous holes 10 is preferably 5 µm or more and 50 µm or less. If the hole opening width W is more than 50 µm, a large force will be applied during division, and failures such as chipping and cracking are likely to occur at the dividing point of the ceramic substrate after dividing. If the hole opening width W is less than 5 µm, only a small force applied during processing or transportation will cause division, making stable production impossible. Furthermore, the hole opening width of the group of non-continuous holes 10 is preferably 10 µm or more and 45 µm or less, more preferably 15 µm or more and 40 µm or less.

A difference between brightness of a laser irradiation scar of the continuous groove 12 and brightness of a surface of the ceramic substrate 4 (groove brightness difference) is preferably 4 or less. If no assist gas is used during laser processing, the surface of the continuous groove 12 will become black due to laser processing residue. The laser residue can be removed by post-treatment; however, if it is left on the surface, it may peel off. In addition, if the residue is conductive, it may reduce the insulating properties of the surface of the ceramic substrate 4. When laser power is increased without using the assist gas, the processing speed can be increased, but damage to the surface of the continuous groove 12 will be greater. Thus, a smaller difference between the brightness of the laser irradiation scar of the continuous groove 12 and the brightness of the surface of the ceramic substrate means smaller damage to the ceramic substrate 4. Furthermore, the difference between the brightness of the laser irradiation scar of the continuous groove 12 and the brightness of the surface of the ceramic substrate 4 is preferably 3 or less, more preferably 2 or less.

The brightness is in accordance with the definition in JIS Z8721 (1993).

The ceramic circuit substrate 13 after division through laser processing can be used for fabrication of a semiconductor. FIG. 9 shows an example of the ceramic circuit substrate 13 according to the embodiment. Reference numerical 3 denotes the metal circuit and reference character 3A denotes the metal heat sink. Three metal circuits are bonded to the front surface of the ceramic substrate 4, and one metal heat sink 3A is bonded to the back surface. In FIG. 1, one metal circuit 3 is formed on the front surface of the ceramic substrate 4, whereas three metal circuits 3 are formed on the front surface of the ceramic substrate 4 in FIG. 9. Thus, the number of metal circuits 3 is not limited. In the ceramic substrate 4 shown in FIG. 9, it is possible to form the metal circuit 3 on the laser-irradiated surface 9 of the ceramic substrate 4 in which the scribe lines are formed. This is because laser scribing of the ceramic substrate 4 can cause little damage and therefore smaller stress during laser scribe formation.

Such a ceramic circuit substrate 13 is suitable for a semiconductor module in which a semiconductor element is mounted on the metal circuit 3 through a bonding layer. FIG. 10 shows an example of the semiconductor module (semiconductor device) according to the embodiment. In FIG. 10, reference numeral 13 denotes a ceramic circuit substrate; reference numeral 14 denotes a semiconductor module; reference numeral 15 denotes wire bonding; reference numeral 16 denotes a semiconductor element; reference numeral 17 denotes a resin mold; and reference numeral 18 denotes a lead frame. In FIG. 10, the semiconductor element 16 is bonded to the metal circuit 3 of the ceramic circuit substrate 13 through the bonding layer (not shown). Similarly, the lead frame 18 is bonded through the bonding layer (not shown). In addition, the semiconductor element 16 and the adjacent metal circuit 3 are connected by the wire bonding 15. The ceramic circuit substrate 13, to which the wire bonding 15 is bonded, is integrated with the resin mold 17 to form the semiconductor module 14. The semiconductor module 14 is not limited to one having such a structure. For example, either the wire bonding 15 or the lead frame 18 can be used. Regarding each of the semiconductor element 16, the wire bonding 15, and the lead frame 18, a plurality thereof may be provided to the metal circuit 3.

Examples of the bonding layer for bonding the semiconductor element 16 or the lead frame 18 includes solder and a brazing material. Lead-free solder is preferable for the solder. The solder refers to one having a melting point of 450°C or less. The brazing material refers to one having a melting point of more than 450°C. Brazing materials having a melting point of 500°C or more are called high-temperature brazing materials. The high-temperature brazing materials may be those including mainly Ag.

In a case where the entire ceramic circuit substrate 13 is sealed with the resin mold 17, it is desirable that the laser-scribed surface be the front surface (on metal circuit 3 side), as in the ceramic circuit substrate 13 shown in FIG. 9. This is because it is difficult for resin to penetrate into the group of non-continuous holes 10 formed by laser scribing, which may result in voids. The voids interfere with heat dissipation, so the scribe line 6 is formed on the front surface (metal circuit 3 side) to prevent the formation of the voids on the metal heat sink 3A side. This is because when the heat generated by the semiconductor element 16 is transferred vertically downward from the ceramic substrate 4 and in the direction of 45° to the verticality, the reduction of heat dissipation on the metal heat sink 3A side due to voids can be prevented.

As the semiconductor element 16 bonded to the metal circuit 3 becomes smaller and smaller, the amount of heat generated by a chip continues to increase. Therefore, it is important to improve heat dissipation in the ceramic circuit substrate 13 on which the semiconductor elements 16 are mounted. In addition, in order to achieve higher performance of the semiconductor module 14, a plurality of the semiconductor elements 16 are now mounted on the ceramic circuit substrate 13. When a temperature of even only one semiconductor element 16 exceeds the intrinsic temperature of the element, the resistance changes to a negative temperature coefficient on the negative side. This causes thermal runaway, in which electric power flows intensively, resulting in instantaneous destruction phenomena. Therefore, it is effective to improve the heat dissipation. The semiconductor modules 14 are also used in a PCU (Power Control Unit), an IGBT (Insulated-Gate Bipolar Transistor), and an IPM (Intelligent Power Module), which are used in inverters for automobiles (including electric vehicles), electric railcars, industrial machinery, air conditioners, and so on. Automobiles are increasingly becoming electric vehicles. Improving the reliability of the semiconductor module 14 will directly lead to the safety of the automobile. The same applies to electric railcars, industrial machinery, etc.

Next, a laser scribing method for a silicon nitride-copper circuit substrate, among the scribed ceramic circuit substrates 1 according to the embodiment, will be described. Although the method for producing a laser scribe line in the silicon nitride substrate is not limited as long as the scribe line has the above configuration, an exemplary method that gives a good yield can be as follows. The following illustrates a case where a scribed ceramic circuit substrate 1 including the silicon nitride substrate as the ceramic substrate 4 and a copper plate as the metal circuit 3 is used.

First, the silicon nitride substrate is provided. In particular, in view of heat dissipation of the entire ceramic circuit substrate 13 including the silicon nitride substrate, it is preferable that the thermal conductivity be 50 W/m·K or more and that the three-point bending strength be 600 MPa or more. When through-holes are used to provide conduction between the metal circuit 3 on the front surface and the metal heat sink 3A on the back surface, a silicon nitride substrate having the through-holes is provided. When providing the through-holes in the silicon nitride substrate, the through-holes may be made in a molded body in advance. The process of providing through-holes in a sintered silicon nitride body may also be performed. The process of providing through-holes includes laser processing similar to laser scribing, machining, etc. Examples of the machining process include drilling with a drill or the like.

Next, a copper plate for the metal circuit is provided. The silicon nitride substrate and the copper plate are preferably bonded through a bonding layer. The bonding layer is preferably an active metal brazing material containing an active metal such as Ti. In addition to Ti, the active metal brazing material contains one of Ag (silver) or Cu as a main component, and the active metal brazing material contains: 0.1 wt% or more and 10 wt% or less of Ti; 10 wt% or more and 60 wt% or less of Cu; and Ag as the balance. One or more elements selected from the group consisting of In (indium), Sn (tin), Al, Si (silicon), C (carbon), and Mg (magnesium) may also be added in an amount of 1 wt% or more and 15 wt% or less, if necessary.

Next, the active metal brazing paste containing an active metal such as Ti is applied to the silicon nitride substrate by printing. The copper plate is placed on the silicon nitride substrate on which the brazing paste has been applied by printing. A bonding process is then performed thereon by heating at a temperature of 600°C or more and 900°C or less. The heating process is performed in a vacuum or non-oxidizing atmosphere, as required. When performed in a vacuum, the pressure is preferably 1×10⁻² Pa or less. The non-oxidizing atmosphere can be a nitrogen atmosphere or an argon atmosphere. By using a vacuum or non-oxidizing atmosphere, oxidation of the bonding layer can be suppressed. This improves the bond strength.

The copper plate to be bonded can be either one that has been worked in advance into a patterned shape for circuit formation or a single plate that has not been worked in to a pattern shape yet and thus can cover the entire surface of the silicon nitride substrate. In a case where the single plate is used, the metal plate is bonded and then subjected to an etching process to work into a patterned shape. It is also possible to apply the brazing material to the entire surface of the silicon nitride substrate by printing, bond the metal plate, and then etch the metal plate together with the brazing material, to thereby form a circuit.

The silicon nitride substrate on which the circuit has been formed is placed on a precision processing table of a fiber laser machine. The fiber laser irradiates the silicon nitride substrate to form the scribe line composed of the continuous groove 12 and the group of non-continuous holes 10. The continuous groove 12 and the group of non-continuous holes 10 of a predetermined size are formed by controlling the conditions of the fiber laser machine. The shape and size of the continuous groove 12 and others formed by irradiation with the fiber laser are as described above.

The finished scribed ceramic circuit substrate 1 is divided to produce a silicon nitride-copper circuit substrate as the ceramic circuit substrate 13. The direction in which force is applied to the scribed ceramic circuit substrate 1 for dividing is preferably from a non-laser surface. Next, the steps of bonding the semiconductor element 16 and others to the silicon nitride-copper circuit substrate is performed. A bonding layer is provided at a position where the semiconductor element is to be bonded. The bonding layer is preferably the solder or the brazing material. The semiconductor element 16 is mounted on the bonding layer provided. If necessary, the lead frame 18 can be also bonded through a bonding layer. If necessary, the wire bonding 15 can be provided. The numbers of the semiconductor elements 16, lead frames 18, and wire bonding 15 provided are each as required. The silicon nitride copper circuit substrate with the semiconductor elements 16, the lead frames 18, and the wire bonding 15 is sealed internally by molding with the resin. It is possible to perform some of these steps before scribing (dividing). For example, the dividing can be performed after the bonding layer is provided.

The laser scribing method for an aluminum nitride metal circuit substrate, among the ceramic circuit substrates 13 according to the embodiment, will be described. First, the aluminum nitride substrate is provided. In particular, in view of heat dissipation of the entire circuit substrate, it is preferable that the thermal conductivity be 170 W/m·K or more and that the three-point bending strength be 350 MPa or more. The method for producing a laser scribe line in the aluminum nitride substrate is not limited as long as the laser scribe line has the above configuration, but the same production processes as for the silicon nitride copper circuit substrate described above can be used to achieve high yields. For example, the specific gravity of silicon nitride or aluminum nitride substrates is about 3.1 to 3.4.

The specific gravity of an aluminum oxide substrate is about 3.0 to 4.0. The specific gravity of a copper plate is about 8.5 to 9.0. Since the metal plate is a heavy component compared with the ceramic substrate, the ceramic circuit substrate to which the metal plate has been bonded is an increased weight. In addition, it is necessary to perform etching or other steps to give the metal plate a circuit shape. This increases the number of times of the transport of the ceramic circuit substrate 13. The fiber laser scribing process on the ceramic circuit substrates 13 can prevent the ceramic circuit substrates 13 from being damaged during transportation. In addition, attempts have been made in recent years to make the copper plate thicker. In other words, the embodiments are suitable for multi-piece taking of the ceramic circuit substrates 13 including the copper plate, especially a copper plate having a thickness of 0.6 mm or more.

### (Examples 1 to 42 and Comparative Examples 1 to 27)

As ceramic substrates for the scribed ceramic circuit substrates according to Examples 1 to 42 and Comparative Examples 1 to 27, silicon nitride substrates of 40 mm in length × 50 mm in width, and 0.32 mm, 0.25 mm and 0.50 mm in thickness, and aluminum nitride substrates of 40 mm in length × 50 mm in width, and 0.64 mm and 0.80 mm in thickness were provided. The silicon nitride substrate as a ceramic substrate had a thermal conductivity of 90 W/m·K and a three-point bending strength of 650 MPa. The aluminum nitride substrate had a thermal conductivity of 170 W/m·K and a three-point bending strength of 400 MPa.

Next, copper plates were bonded to both sides of the ceramic substrate using the active metal bonding method. The copper plate was made of oxygen-free copper and having a size of 40 mm in length × 50 mm in width × 0.5 mm in thickness. The active metal brazing material used in the active metal bonding method was an active metal paste prepared by mixing 2 wt% of Ti, 10 wt% of Sn, 30 wt% of Cu, and the balance of Ag with organic components to form a paste. The active metal paste was applied to the front surface of the ceramic substrate by printing using a screen printer having a screen mesh of 320×320 mm with 250 mesh made of stainless steel V, followed by drying, and then the active metal paste was also applied by printing and dried on the back surface.

A copper plate was placed on each of the front and back surfaces of the ceramic substrate after the paste was applied and dried, and then the resultant was sandwiched by a plate jig, weighted from above, and heat bonded. The heat bonding was performed at a bonding temperature of 810°C for a bonding time of 10 minutes in a vacuum (1×10⁻² Pa or less) .

After the heat bonding, the copper plate was etched to form a circuit shape. The copper plate on the front surface was formed into the circuit shape with pullbacks in three places, and the copper plate on the back surface was also etched to form pullbacks around it.

Then, on 101 substrates, six scribe lines per substrate were formed on the front surface side of a ceramic substrate before being divided, as shown in FIG. 1, by laser processes using fiber laser with assist gas under each condition of Examples 1 to 42 and Comparative Examples 1 to 6, 8 to 13, 15 to 22, and 24 to 26. In Comparative Examples 7, 14, 23, and 27, the processes were performed without assist gas. One of the scribed ceramic circuit substrates after laser processing under each condition was divided, and the area near the center of the cross-sectioned substrate of the ceramic circuit substrate after division (position of approximately 10 mm from the edge) was observed and photographed at a magnification of 100x by SEM. Lines were drawn at the surface of the substrate, through the deepest point of the continuous grooves, and through the deepest point of the group of non-continuous holes, and the distances between them were measured to determine the depth of the continuous groove, D1, and the depth of the group of non-continuous holes, D2.

The inter-hole distance P and the hole opening width W of the group of non-continuous holes were obtained by measuring the inter-hole distance and the hole opening width W of the adjacent non-continuous holes for 10 consecutive points in the photograph and then arithmetically averaging the found values. The measurement results of Examples and Comparative Examples are shown in Table 1. In Table 1, the silicon nitride substrate is denoted as Si₃N₄ and the aluminum nitride substrate is denoted as AlN.

For the scribed ceramic circuit substrates, which were divided under each condition and observed in the SEM photographs, the brightness was measured on the surface and the continuous groove thereof by a micro-spectrophotometer to determine the difference. The measurement results of Examples and Comparative Examples are shown in Table 2.

**[Table 1]**

| Example | Ceramic Board | Thickness T [mm] of Substrate | Depth D1 [µm] of Continuous Groove | Depth D2 [µm] of Group of Non-Continuous Holes |
|---|---|---|---|---|
| Example 1 | Si₃N₄ | 0.32 | 50 | 0 |
| Example 2 | Si₃N₄ | 0.32 | 50 | 0 |
| Example 3 | Si₃N₄ | 0.32 | 50 | 140 |
| Example 4 | Si₃N₄ | 0.32 | 50 | 140 |
| Example 5 | Si₃N₄ | 0.32 | 50 | 140 |
| Example 6 | Si₃N₄ | 0.32 | 50 | 140 |
| Example 7 | Si₃N₄ | 0.32 | 50 | 140 |
| Example 8 | Si₃N₄ | 0.32 | 50 | 140 |
| Example 9 | Si₃N₄ | 0.32 | 155 | 0 |
| Example 10 | Si₃N₄ | 0.32 | 155 | 0 |
| Example 11 | Si₃N₄ | 0.32 | 155 | 140 |
| Example 12 | Si₃N₄ | 0.32 | 155 | 140 |
| Example 13 | Si₃N₄ | 0.32 | 155 | 140 |
| Example 14 | Si₃N₄ | 0.32 | 155 | 140 |
| Example 15 | Si₃N₄ | 0.32 | 155 | 140 |
| Example 16 | Si₃N₄ | 0.32 | 155 | 140 |
| Example 17 | Si₃N₄ | 0.32 | 155 | 140 |
| Example 18 | Si₃N₄ | 0.32 | 155 | 140 |
| Example 19 | Si₃N₄ | 0.25 | 45 | 0 |
| Example 20 | Si₃N₄ | 0.25 | 45 | 0 |
| Example 21 | Si₃N₄ | 0.25 | 120 | 110 |
| Example 22 | Si₃N₄ | 0.25 | 120 | 110 |
| Example 23 | Si₃N₄ | 0.25 | 120 | 110 |
| Example 24 | Si₃N₄ | 0.25 | 120 | 110 |
| Example 25 | Si₃N₄ | 0.25 | 120 | 110 |
| Example 26 | Si₃N₄ | 0.25 | 120 | 110 |
| Example 27 | Si₃N₄ | 0.25 | 120 | 110 |
| Example 28 | Si₃N₄ | 0.25 | 120 | 110 |
| Example 29 | Si₃N₄ | 0.50 | 80 | 0 |
| Example 30 | Si₃N₄ | 0.50 | 80 | 0 |
| Example 31 | Si₃N₄ | 0.50 | 240 | 220 |
| Example 32 | Si₃N₄ | 0.50 | 240 | 220 |
| Example 33 | Si₃N₄ | 0.50 | 240 | 220 |
| Example 34 | Si₃N₄ | 0.50 | 240 | 220 |
| Example 35 | Si₃N₄ | 0.50 | 240 | 220 |
| Example 36 | Si₃N₄ | 0.50 | 240 | 220 |
| Example 37 | Si₃N₄ | 0.50 | 240 | 220 |
| Example 38 | Si₃N₄ | 0.50 | 240 | 220 |
| Example 39 | AlN | 0.64 | 100 | 0 |
| Example 40 | AlN | 0.64 | 310 | 280 |
| Example 41 | AlN | 0.80 | 130 | 0 |
| Example 42 | AlN | 0.80 | 380 | 350 |
| Comparative Example 1 | Si₃N₄ | 0.32 | 38 | 0 |
| Comparative Example 2 | Si₃N₄ | 0.32 | 55 | 150 |
| Comparative Example 3 | Si₃N₄ | 0.32 | 55 | 140 |
| Comparative Example 4 | Si₃N₄ | 0.32 | 55 | 140 |
| Comparative Example 5 | Si₃N₄ | 0.32 | 55 | 140 |
| Comparative Example 6 | Si₃N₄ | 0.32 | 55 | 140 |
| Comparative Example 7 | Si₃N₄ | 0.32 | 55 | 140 |
| Comparative Example 8 | Si₃N₄ | 0.25 | 36 | 0 |
| Comparative Example 9 | Si₃N₄ | 0.25 | 55 | 150 |
| Comparative Example 10 | Si₃N₄ | 0.25 | 55 | 140 |
| Comparative Example 11 | Si₃N₄ | 0.25 | 55 | 140 |
| Comparative Example 12 | Si₃N₄ | 0.25 | 55 | 140 |
| Comparative Example 13 | Si₃N₄ | 0.25 | 55 | 140 |
| Comparative Example 14 | Si₃N₄ | 0.25 | 55 | 140 |
| Comparative Example 15 | Si₃N₄ | 0.50 | 38 | 0 |
| Comparative Example 16 | Si₃N₄ | 0.50 | 70 | 0 |
| Comparative Example 17 | Si₃N₄ | 0.50 | 260 | 0 |
| Comparative Example 18 | Si₃N₄ | 0.50 | 240 | 230 |
| Comparative Example 19 | Si₃N₄ | 0.50 | 80 | 140 |
| Comparative Example 20 | Si₃N₄ | 0.50 | 80 | 140 |
| Comparative Example 21 | Si₃N₄ | 0.50 | 80 | 140 |
| Comparative Example 22 | Si₃N₄ | 0.50 | 80 | 140 |
| Comparative Example 23 | Si₃N₄ | 0.50 | 80 | 140 |
| Comparative Example 24 | Si₃N₄ | 0.32 | 55 | 0 |
| Comparative Example 25 | Si₃N₄ | 0.32 | 55 | 140 |
| Comparative Example 26 | AlN | 0.64 | 90 | 0 |
| Comparative Example 27 | AlN | 0.80 | 380 | 300 |

| Example | D1/T | D2/T | Inter-Hole Distance P [µm] | Hole Opening Width W [µm] |
|---|---|---|---|---|
| Example 1 | 0.16 | 0.00 | - | - |
| Example 2 | 0.16 | 0.00 | - | - |
| Example 3 | 0.16 | 0.44 | 12 | 6 |
| Example 4 | 0.16 | 0.44 | 12 | 12 |
| Example 5 | 0.16 | 0.44 | 98 | 6 |
| Example 6 | 0.16 | 0.44 | 98 | 6 |
| Example 7 | 0.16 | 0.44 | 98 | 48 |
| Example 8 | 0.16 | 0.44 | 98 | 48 |
| Example 9 | 0.48 | 0.00 | - | - |
| Example 10 | 0.48 | 0.00 | - | - |
| Example 11 | 0.48 | 0.44 | 12 | 6 |
| Example 12 | 0.48 | 0.44 | 12 | 6 |
| Example 13 | 0.48 | 0.44 | 12 | 12 |
| Example 14 | 0.48 | 0.44 | 12 | 12 |
| Example 15 | 0.48 | 0.44 | 98 | 6 |
| Example 16 | 0.48 | 0.44 | 98 | 6 |
| Example 17 | 0.48 | 0.44 | 98 | 48 |
| Example 18 | 0.48 | 0.44 | 98 | 48 |
| Example 19 | 0.18 | 0.00 | - | - |
| Example 20 | 0.18 | 0.00 | - | - |
| Example 21 | 0.48 | 0.44 | 12 | 6 |
| Example 22 | 0.48 | 0.44 | 12 | 6 |
| Example 23 | 0.48 | 0.44 | 12 | 12 |
| Example 24 | 0.48 | 0.44 | 12 | 12 |
| Example 25 | 0.48 | 0.44 | 98 | 6 |
| Example 26 | 0.48 | 0.44 | 98 | 6 |
| Example 27 | 0.48 | 0.44 | 98 | 48 |
| Example 28 | 0.48 | 0.44 | 98 | 48 |
| Example 29 | 0.16 | 0.00 | - | - |
| Example 30 | 0.16 | 0.00 | - | - |
| Example 31 | 0.48 | 0.44 | 12 | 6 |
| Example 32 | 0.48 | 0.44 | 12 | 6 |
| Example 33 | 0.48 | 0.44 | 12 | 12 |
| Example 34 | 0.48 | 0.44 | 12 | 12 |
| Example 35 | 0.48 | 0.44 | 98 | 6 |
| Example 36 | 0.48 | 0.44 | 98 | 6 |
| Example 37 | 0.48 | 0.44 | 98 | 48 |
| Example 38 | 0.48 | 0.44 | 98 | 48 |
| Example 39 | 0.16 | 0.00 | - | - |
| Example 40 | 0.48 | 0.44 | 98 | 48 |
| Example 41 | 0.16 | 0.00 | - | - |
| Example 42 | 0.48 | 0.44 | 98 | 48 |
| Comparative Example 1 | 0.12 | 0.00 | - | - |
| Comparative Example 2 | 0.17 | 0.47 | 98 | 48 |
| Comparative Example 3 | 0.17 | 0.44 | 8 | 5 |
| Comparative Example 4 | 0.17 | 0.44 | 10 | 4 |
| Comparative Example 5 | 0.17 | 0.44 | 102 | 5 |
| Comparative Example 6 | 0.17 | 0.44 | 98 | 52 |
| Comparative Example 7 | 0.17 | 0.44 | 12 | 6 |
| Comparative Example 8 | 0.14 | 0.00 | - | - |
| Comparative Example 9 | 0.22 | 0.60 | 98 | 48 |
| Comparative Example 10 | 0.22 | 0.56 | 8 | 5 |
| Comparative Example 11 | 0.22 | 0.56 | 10 | 4 |
| Comparative Example 12 | 0.22 | 0.44 | 102 | 5 |
| Comparative Example 13 | 0.22 | 0.44 | 98 | 52 |
| Comparative Example 14 | 0.22 | 0.44 | 12 | 6 |
| Comparative Example 15 | 0.08 | 0.00 | - | - |
| Comparative Example 16 | 0.14 | 0.00 | - | - |
| Comparative Example 17 | 0.52 | 0.00 | - | - |
| Comparative Example 18 | 0.48 | 0.46 | 12 | 6 |
| Comparative Example 19 | 0.16 | 0.28 | 8 | 5 |
| Comparative Example 20 | 0.16 | 0.28 | 10 | 4 |
| Comparative Example 21 | 0.16 | 0.28 | 102 | 5 |
| Comparative Example 22 | 0.16 | 0.28 | 98 | 52 |
| Comparative Example 23 | 0.16 | 0.28 | 12 | 6 |
| Comparative Example 24 | 0.17 | 0.00 | - | - |
| Comparative Example 25 | 0.17 | 0.44 | 12 | 6 |
| Comparative Example 26 | 0.14 | 0.00 | - | - |
| Comparative Example 27 | 0.48 | 0.38 | 120 | 60 |

Then, the laser-processed scribed ceramic circuit substrates were divided by an automatic substrate divider to obtain ceramic circuit substrates. The appearance of the ceramic circuit substrate was inspected and any breakage residue, and chipping or cracking that occurred around the perimeter of the substrate were counted as scribing failures.

Withstand voltage tests were performed on the scribed ceramic circuit substrate between the front and back surfaces of the substrate. The withstand voltage test was performed using a high-voltage tester manufactured by Kikusui Electronics Corporation. A voltage of 5 kV was applied for 1 minute between the metal circuits (three locations) on the front surface and the metal heat sink on the back surface in cases where the thickness of the ceramic substrate was 0.5 mm. The scribed ceramic circuit substrate was evaluated on a basis of a failure rate (%), wherein a case where conduction occurred was failure.

A semiconductor element was mounted in a central circuit section of the ceramic circuit substrate according to each of Examples and Comparative Examples. Next, wire bonding was performed. Then, resin molding was performed by a transfer molding method. Next, for the ceramic circuit substrate according to each of Examples and Comparative Examples, the porosity between the resin and the ceramic circuit substrate was determined by scanning acoustic tomography (SAT) along the perimeter of the substrate on the metal heat sink side to which the semiconductor element was not bonded. The porosity (%) was calculated using the formula: (a total length of the portion where the resin did not adhere to the ceramic substrate so that voids were present/a length around the ceramic substrate) ×100, and a case where a porosity was less than 95% were defined as resin peeling failure.

The results obtained for Examples and Comparative Examples are shown in Table 2. Regarding the scribed surface, the side where the metal circuits were etched at three locations and bonded to the semiconductor element was referred to as the circuit side, and the opposite side was referred to as the non-circuit side.

**[Table 2]**

| Example | Difference in Brightness for Groove | Scribed Surface Side |
|---|---|---|
| Example 1 | <1 | Circuit Side |
| Example 2 | 4 | Circuit Side |
| Example 3 | <1 | Circuit Side |
| Example 4 | 4 | Circuit Side |
| Example 5 | <1 | Circuit Side |
| Example 6 | 4 | Circuit Side |
| Example 7 | <1 | Circuit Side |
| Example 8 | 4 | Circuit Side |
| Example 9 | <1 | Circuit Side |
| Example 10 | 4 | Circuit Side |
| Example 11 | <1 | Circuit Side |
| Example 12 | 4 | Circuit Side |
| Example 13 | <1 | Circuit Side |
| Example 14 | 4 | Circuit Side |
| Example 15 | <1 | Circuit Side |
| Example 16 | 4 | Circuit Side |
| Example 17 | <1 | Circuit Side |
| Example 18 | 4 | Circuit Side |
| Example 19 | <1 | Circuit Side |
| Example 20 | 4 | Circuit Side |
| Example 21 | <1 | Circuit Side |
| Example 22 | 4 | Circuit Side |
| Example 23 | <1 | Circuit Side |
| Example 24 | 4 | Circuit Side |
| Example 25 | <1 | Circuit Side |
| Example 26 | 4 | Circuit Side |
| Example 27 | <1 | Circuit Side |
| Example 28 | 4 | Circuit Side |
| Example 29 | <1 | Circuit Side |
| Example 30 | 4 | Circuit Side |
| Example 31 | <1 | Circuit Side |
| Example 32 | 4 | Circuit Side |
| Example 33 | <1 | Circuit Side |
| Example 34 | 4 | Circuit Side |
| Example 35 | <1 | Circuit Side |
| Example 36 | 4 | Circuit Side |
| Example 37 | <1 | Circuit Side |
| Example 38 | 4 | Circuit Side |
| Example 39 | <1 | Circuit Side |
| Example 40 | 4 | Circuit Side |
| Example 41 | <1 | Circuit Side |
| Example 42 | 4 | Circuit Side |
| Comparative Example 1 | <1 | Circuit Side |
| Comparative Example 2 | <1 | Circuit Side |
| Comparative Example 3 | <1 | Circuit Side |
| Comparative Example 4 | <1 | Circuit Side |
| Comparative Example 5 | <1 | Circuit Side |
| Comparative Example 6 | <1 | Circuit Side |
| Comparative Example 7 | 5 | Circuit Side |
| Comparative Example 8 | <1 | Circuit Side |
| Comparative Example 9 | <1 | Circuit Side |
| Comparative Example 10 | <1 | Circuit Side |
| Comparative Example 11 | <1 | Circuit Side |
| Comparative Example 12 | <1 | Circuit Side |
| Comparative Example 13 | <1 | Circuit Side |
| Comparative Example 14 | 5 | Circuit Side |
| Comparative Example 15 | <1 | Circuit Side |
| Comparative Example 16 | <1 | Circuit Side |
| Comparative Example 17 | <1 | Circuit Side |
| Comparative Example 18 | <1 | Circuit Side |
| Comparative Example 19 | <1 | Circuit Side |
| Comparative Example 20 | <1 | Circuit Side |
| Comparative Example 21 | <1 | Circuit Side |
| Comparative Example 22 | <1 | Circuit Side |
| Comparative Example 23 | 5 | Circuit Side |
| Comparative Example 24 | <1 | Non-Circuit Side |
| Comparative Example 25 | <1 | Non-Circuit Side |
| Comparative Example 26 | <1 | Circuit Side |
| Comparative Example 27 | 5 | Non-Circuit Side |

| Example | Scribing Failure Rate [%] | Withstand Voltage Failure Rate [%] | Resin Peeling Failure Rate [%] |
|---|---|---|---|
| Example 1 | 3 | 0 | 0 |
| Example 2 | 2 | 0 | 0 |
| Example 3 | 0 | 0 | 0 |
| Example 4 | 0 | 1 | 0 |
| Example 5 | 0 | 0 | 0 |
| Example 6 | 0 | 0 | 0 |
| Example 7 | 0 | 0 | 0 |
| Example 8 | 0 | 0 | 0 |
| Example 9 | 3 | 0 | 0 |
| Example 10 | 2 | 0 | 0 |
| Example 11 | 0 | 1 | 1 |
| Example 12 | 0 | 1 | 2 |
| Example 13 | 0 | 0 | 1 |
| Example 14 | 0 | 0 | 1 |
| Example 15 | 0 | 0 | 0 |
| Example 16 | 0 | 1 | 1 |
| Example 17 | 0 | 0 | 0 |
| Example 18 | 0 | 2 | 1 |
| Example 19 | 3 | 0 | 0 |
| Example 20 | 2 | 0 | 0 |
| Example 21 | 3 | 2 | 1 |
| Example 22 | 0 | 0 | 0 |
| Example 23 | 0 | 1 | 2 |
| Example 24 | 0 | 0 | 0 |
| Example 25 | 0 | 1 | 1 |
| Example 26 | 0 | 0 | 0 |
| Example 27 | 0 | 1 | 1 |
| Example 28 | 0 | 0 | 0 |
| Example 29 | 0 | 2 | 0 |
| Example 30 | 3 | 1 | 0 |
| Example 31 | 0 | 0 | 0 |
| Example 32 | 0 | 1 | 1 |
| Example 33 | 0 | 0 | 0 |
| Example 34 | 0 | 1 | 1 |
| Example 35 | 0 | 0 | 1 |
| Example 36 | 0 | 2 | 0 |
| Example 37 | 0 | 0 | 1 |
| Example 38 | 0 | 1 | 0 |
| Example 39 | 2 | 0 | 0 |
| Example 40 | 0 | 3 | 2 |
| Example 41 | 2 | 0 | 0 |
| Example 42 | 0 | 1 | 2 |
| Comparative Example 1 | 12 | 0 | 0 |
| Comparative Example 2 | 4 | 0 | 0 |
| Comparative Example 3 | 9 | 0 | 0 |
| Comparative Example 4 | 10 | 0 | 0 |
| Comparative Example 5 | 9 | 0 | 0 |
| Comparative Example 6 | 5 | 0 | 0 |
| Comparative Example 7 | 0 | 10 | 1 |
| Comparative Example 8 | 12 | 0 | 0 |
| Comparative Example 9 | 5 | 0 | 1 |
| Comparative Example 10 | 9 | 0 | 0 |
| Comparative Example 11 | 10 | 1 | 0 |
| Comparative Example 12 | 9 | 0 | 0 |
| Comparative Example 13 | 4 | 0 | 0 |
| Comparative Example 14 | 0 | 13 | 0 |
| Comparative Example 15 | 9 | 0 | 0 |
| Comparative Example 16 | 12 | 0 | 0 |
| Comparative Example 17 | 4 | 1 | 0 |
| Comparative Example 18 | 4 | 2 | 1 |
| Comparative Example 19 | 5 | 0 | 0 |
| Comparative Example 20 | 7 | 0 | 0 |
| Comparative Example 21 | 5 | 0 | 0 |
| Comparative Example 22 | 4 | 0 | 0 |
| Comparative Example 23 | 0 | 9 | 0 |
| Comparative Example 24 | 0 | 0 | 11 |
| Comparative Example 25 | 0 | 3 | 10 |
| Comparative Example 26 | 10 | 0 | 0 |
| Comparative Example 27 | 9 | 9 | 8 |

As can be seen from Tables 1 and 2, in the scribed ceramic circuit substrates according to Examples 1 to 42, the depth of the continuous groove D1 of the ceramic substrate was more than 40 µm; the depth of the continuous groove/the thickness of the substrate (D1/T) was 0.15 or more and 0.5 or less; the depth of the group of non-continuous holes/the thickness of the substrate (D2/T) was more than 0 and 0.45 or less; and the difference in the brightness for the groove and the scribed surface side were within the desirable ranges. The scribed ceramic circuit substrates according to Comparative Examples 1 to 27 were outside the desirable ranges.

The ceramic circuit substrates produced from the scribed ceramic circuit substrates according to Examples 1 to 42 had no scribing failure or a low failure rate. This was because laser scribe lines were formed that enabled division of the scribed ceramic circuit substrate by a certain load. In contrast, Comparative Examples 1 to 6, 8 to 13, 15 to 22, 26, and 27 had many scribing failures. The reason for this was as follows: adequate laser scribe lines were not formed and it was thus impossible to divide the scribed ceramic circuit substrate along the line by a certain load, resulting in chipping and cracking failures.

The ceramic circuit substrates produced from the scribed ceramic circuit substrates according to Examples 1 to 42 had no withstand voltage failure or a low failure rate. This was due to a reduction in the formation of residues that cause withstand voltage failures during laser processing. In contrast, many withstand voltage failures occurred in Comparative Examples 7, 14, 23, and 27. This was because the residue formed during laser scribing served as a starting point for electrical conduction.

In addition, the ceramic circuit substrates produced from the scribed ceramic circuit substrates according to Examples 1 to 42 had no resin peeling failure or a low failure rate. The reason for this was as follows: there were no residues of laser processing for laser scribing or no traces of continuous grooves or groups of non-continuous holes in the resin-molded areas, resulting in no failure in bonding due to laser residues or no void due to traces of the continuous groove or the group of non-continuous holes. In contrast, many resin peeling failures occurred in Comparative Examples 24, 25, and 27. This was because failure in bonding due to the laser residue and the voids due to the continuous groove and the group of non-continuous holes caused the peeling failures.

While certain embodiments have been described, these embodiments have been presented by way of example only, and are not intended to limit the scope of the inventions. Indeed, the novel methods and systems described herein may be embodied in a variety of other forms; furthermore, various omissions, substitutions and changes in the form of the methods and systems described herein may be made without departing from the spirit of the inventions. The accompanying claims and their equivalents are intended to cover such forms or modifications as would fall within the scope and spirit of the inventions.

## Claims

1. A scribed ceramic circuit substrate comprising: a ceramic circuit substrate including a ceramic substrate and a metal circuit bonded thereto; and a scribe line defining the ceramic substrate, wherein the scribe line includes a continuous groove on a front surface side thereof, and the continuous groove is composed of a plurality of holes connected to each other, the plurality of holes formed by fiber laser irradiation,
wherein a depth of the continuous groove is more than 40 µm, and 0.15 times or more and 0.5 times or less a thickness of the ceramic substrate.

2. The scribed ceramic circuit substrate according to claim 1, wherein the scribe line includes a group of non-continuous holes on a deeper side thereof, and the group of non-continuous holes is composed of a plurality of holes not connected to each other, the plurality of holes formed by the fiber laser irradiation.

3. The scribed ceramic circuit substrate according to claim 2, wherein a depth of the group of non-continuous holes is more than 0 and 0.45 times or less the thickness of the ceramic substrate.

4. The scribed ceramic circuit substrate according to claim 2 or 3, wherein a distance between adjacent holes of the group of non-continuous holes is 10 µm or more and 100 µm or less.

5. The scribed ceramic circuit substrate according to any one of claims 2 to 4, wherein a width of each hole of the group of non-continuous holes is 5 µm or more and 50 µm or less.

6. The scribed ceramic circuit substrate according to any one of claims 1 to 4, wherein a difference between brightness of a laser irradiation scar of the continuous groove and brightness of a surface of the ceramic substrate is 4 or less.

7. The scribed ceramic circuit substrate according to any one of claims 1 to 6, wherein the ceramic substrate is a silicon nitride substrate or an aluminum nitride substrate.

8. The scribed ceramic circuit substrate according to any one of claims 1 to 7, wherein the scribe line is formed on a side on which the metal circuit is formed.

9. A ceramic circuit substrate comprising four scribe lines, wherein at least one of the four scribe lines includes a continuous groove on a front surface side thereof, and the continuous groove is composed of a plurality of holes connected to each other, the plurality of holes formed by laser irradiation, and
wherein a depth of the continuous groove is more than 40 µm, and 0.15 times or more and 0.5 times or less a thickness of a ceramic substrate.

10. The ceramic circuit substrate according to claim 9, wherein the scribe line includes a group of non-continuous holes on a deeper side thereof, and the group of non-continuous holes is composed of a plurality of holes not connected to each other, the plurality of holes formed by the fiber laser irradiation.

11. A method for producing a scribed ceramic circuit substrate, comprising: forming continuous groove by a fiber laser on the front surface side of the scribed ceramic circuit substrate according to any one of claims 1 to 8; and then forming a group of non-continuous holes by a fiber laser on a deeper side, wherein the group of non-continuous holes is composed of a plurality of holes not connected to each other.

12. A method for producing a ceramic circuit substrate, comprising applying stress to the scribed ceramic circuit substrate according to any one of claims 1 to 8, and dividing it along the scribe line to produce a ceramic circuit substrate.

13. A method for producing a semiconductor device, comprising the method for producing the ceramic circuit substrate according to claim 12, and comprising mounting a semiconductor element on the ceramic circuit substrate to produce a semiconductor device.

14. The method for producing the semiconductor device according to claim 13, comprising integrating the ceramic circuit substrate and the semiconductor element by resin molding.
